(19) 

Europäisches
Patentamt
European
Patent Office
Office européen
des brevets

(11) **EP 1 962 295 A1**

(12) **EUROPEAN PATENT APPLICATION**
published in accordance with Art. 158(3) EPC

(43) Date of publication:
**27.08.2008 Bulletin 2008/35**

(21) Application number: **06822271.0**

(22) Date of filing: **25.10.2006**

(51) Int Cl.:
*H01B 5/14* (2006.01)    *H01B 13/00* (2006.01)
*H01J 11/00* (2006.01)

(86) International application number:
**PCT/JP2006/321294**

(87) International publication number:
**WO 2007/049653 (03.05.2007 Gazette 2007/18)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **28.10.2005 JP 2005314139**

(71) Applicant: **Asahi Glass Company, Limited
Chiyoda-ku
Tokyo 100-8405 (JP)**

(72) Inventors:
• **SATOH, Ryohei**

  **(JP)**
• **NAKAGAWA, Koji**

  **(JP)**
• **MORINAGA, Eiji**

  **(JP)**

• **USUI, Reo**

  **(JP)**
• **ISONO, Takamitsu**

  **(JP)**
• **TANAKA, Kenji**

  **(JP)**
• **TAKAKI, Satoru**

  **(JP)**
• **EBATA, Kenichi**

  **(JP)**
• **SAKAMOTO, Hiroshi**

  **(JP)**

(74) Representative: **Müller-Boré & Partner
Patentanwälte
Grafinger Strasse 2
81671 München (DE)**

(54) **TRANSPARENT SUBSTRATE WITH THIN FILM AND METHOD FOR MANUFACTURING
TRANSPARENT SUBSTRATE WITH CIRCUIT PATTERN WHEREIN SUCH TRANSPARENT
SUBSTRATE WITH THIN FILM IS USED**

(57)    An object of the invention is to provide a method for manufacturing a transparent substrate provided with a tin oxide thin film which can be satisfactorily patterned even by irradiation with a laser light having low energy because an ablation phenomenon occurs therewith. The invention relates to a method for manufacturing a transparent substrate bearing a circuit pattern, which comprises irradiating a thin-film-attached transparent substrate comprising a transparent substrate having thereon a transparent conductive film having a carrier concentration of $5 \times 10^{19}$ /cm$^3$ or higher, with a laser light having a wavelength of 1,064 nm to form a circuit pattern on the transparent substrate.

**EP 1 962 295 A1**

# Fig. 2

**Description**

TECHNICAL FIELD

The present invention relates to a transparent substrate provided with a thin film comprising tin oxide as a main component, and to a method for manufacturing a circuit-pattern-bearing transparent substrate using the same.

BACKGROUND ART

Electronic circuit substrates constituted of a substrate having thereon a circuit pattern made of a thin film-shaped metal or insulator have been used in computers, communications, domestic electrical appliances for information, various display devices, etc.
Furthermore, in flat panel displays (FPDs) such as plasma displays and liquid-crystal displays, the demand for which has been growing in recent years, it is essential to form a transparent thin-film electrode circuit pattern.

For forming such a circuit pattern, a method using a photolithography/etching process has been generally employed. In this method, a thin film for circuit pattern formation is formed on the whole or part of the surface of a substrate. Thereafter, a resist is applied/dried to form a resist layer.
This resist layer is exposed to light through a mask and developed to thereby form a pattern reverse to the circuit pattern (reverse-circuit pattern). This method thereafter includes etching and resist layer removal to form a desired circuit pattern.
This method is excellent in suitability for mass production because it has satisfactory pattern formation precision to enable the same pattern to be reproduced many times and because two or more circuit patterns can be formed on the same substrate.

However, this method using a photolithography/etching process generally is one in which many steps are repeatedly conducted to complete a circuit. Specifically, a thin metal film is formed on a substrate, and then a resist layer is thereafter formed, which is followed by exposure, development, etching, and resist layer removal. Furthermore, after an insulating layer is formed, resist layer formation, exposure, development, etching, and resist layer removal are conducted.

Thus, the method thus necessitates an extremely large number of steps including film formation, resist application, drying, exposure, development, etching, and resist layer removal, for each time when a circuit pattern constituted of a thin metal film and an insulating layer is to be formed. Because of this, there has been a problem that use of the method results in an exceedingly high production cost.
Furthermore, in that method, a developing liquid, a chemical such as etchant, and a cleaning liquid should be used in large amounts for each series of such many steps. This not only merely results in a poor yield and a significant increase of the production cost, but also has posed a problem that the method imposes a heavy burden on the environment concerning, e.g., waste liquid treatment, which has recently become a matter of serious concern.
Furthermore, etching with an etchant or the like is difficult depending on the kind of the material used for the thin metal film, etc. Consequently, the materials applicable to the photolithography/etching process have been limited to specific materials having excellent suitability for etching.

Examples of conventional techniques relating to such various problems include the following methods of patterning with a laser light described in patent documents 1 and 2.
Patent document 1 discloses a method of thin-film pattern formation which is intended to enable patterning to be conducted without fail and without using a wet process and thereby attain refinement of thin-film circuit patterns, and shortening and simplification of the process. This method of thin-film pattern formation is characterized by pattern-wise forming a stencil on the surface of a substrate, subsequently depositing a thin film to be formed on the substrate bearing the stencil, irradiating with energy beams from the back side of the substrate, and removing the stencil to pattern the thin film.

Patent document 2 discloses a method for liquid-crystal display element production which is intended to conduct the development of a resist film, removal of the residual resist, and processing of a thin metal film or thin semiconductor film or of a thin insulator film, each by a completely dry process. This production method is characterized by: applying a resist film constituted of a polymer material having urethane bonds and/or urea bonds on a glass substrate having either a thin film for constituting a liquid-crystal display element selected from a metal film, dielectric insulating film and semiconductor film, or having a multilayer film composed of such thin films which have been partly patterned and multilayered; irradiating the resist film with an excimer laser through a mask having a given opening pattern to remove irradiated areas of the resist film by ablation phenomenon and thereby form a resist film pattern in which the thin film is exposed according to the opening pattern of the mask; etching and removing the thin film exposed in the resist film pattern; and then irradiating the residual resist film with an excimer laser to remove the resist film by ablation phenomenon.

Patent Document 1: JP-A-6-13356
Patent Document 2: JP-A-10-20509

DISCLOSURE OF THE INVENTION

PROBLEMS THAT THE INVENTION IS TO SOLVE

In the case where a circuit pattern for a transparent thin-film electrode for FPDs or the like is to be formed by such a patterning method employing a laser light, the use of tin oxide as a material for the transparent thin-film electrode is conceivable.

However, when a thin film comprising tin oxide as a main component is formed on a transparent substrate and irradiated with a generally used YAG laser light having a wavelength of 1,064 nm (hereinafter, the term "YAG laser light" always means that having a wavelength of 1,064 nm) to pattern the thin film, there has generally been a problem that the laser light mostly passes through the thin film, making it impossible to conduct efficient patterning with satisfactory reproducibility. Furthermore, there has been a problem that if the energy of the laser is increased in order to conduct processing, the transparent substrate, e.g., glass, may be damaged.

The reasons for those problems are as follows. Tin oxide films have a low absorptivity with respect to the laser light having a wavelength of 1,064 nm and, hence, involve a high vaporization energy and hardly undergo ablation phenomenon. In addition, the exceedingly low absorptivity is apt to fluctuate and this reduces reproducibility. In general, a thin film comprising tin oxide as a main component cannot be removed from the transparent substrate and patterned with satisfactory reproducibility unless the film is irradiated with a high-energy laser light for a long time period.

Accordingly, an object of the invention is to provide a transparent substrate bearing a circuit pattern of a transparent conductive film, particularly a thin film comprising tin oxide as a main component, in which the transparent substrate, e.g., glass, has suffered little damage. Another object is to provide a method for manufacturing the circuit-pattern-bearing transparent substrate.

MEANS FOR SOLVING THE PROBLEMS

The present inventors diligently made investigations in order to accomplish those objects. As a result, it has been found that when a thin-film-attached transparent substrate having a transparent conductive film, particularly a thin film comprising tin oxide as a main component, which has a carrier concentration not lower than a specific value and is formed on the surface of the substrate is used, then the transparent conductive film can be patterned by irradiation with YAG laser light with satisfactory reproducibility without damaging the transparent substrate.

Namely, the invention provides the following (1) to (11).

(1) A thin-film-attached transparent substrate, which comprises a transparent substrate having thereon a transparent conductive film having a carrier concentration of $5 \times 10^{19}$ /cm$^3$ or higher.

(2) The thin-film-attached transparent substrate as described in (1) above, wherein the transparent conductive film is a thin film comprising tin oxide as the main component.

(3) The thin-film-attached transparent substrate as described in (1) or (2) above, wherein the transparent conductive film has a thickness of 50-500 nm.

(4) The thin-film-attached transparent substrate as described in any one of (1) to (3) above, wherein the transparent conductive film can be patterned with a laser light having a wavelength of 1,064 nm.

(5) A method for manufacturing a transparent substrate bearing a circuit pattern, which comprises irradiating the thin-film-attached transparent substrate as described in any one of (1) to (4) above with a laser light having a wavelength of 1,064 nm to form a circuit pattern on the transparent substrate.

(6) The method for manufacturing a transparent substrate bearing a circuit pattern as described in (5) above, wherein the thin-film-attached transparent substrate is obtained by forming a transparent conductive film on a transparent substrate, followed by an annealing treatment.

(7) A circuit-pattern-bearing transparent substrate manufactured by the method for manufacturing a transparent substrate bearing a circuit pattern as described in (5) or (6) above.

(8) An electronic circuit device using the thin-film-attached transparent substrate as described in any one of (1) to (4) and (7) above.

(9) A plasma display panel employing the thin-film-attached transparent substrate as described in any one of (1) to (4) and (7) above.

(10) A method for manufacturing an electronic circuit device which comprises manufacturing the device by the method for manufacturing a transparent substrate bearing a circuit pattern as described in (5) or (6) above.

(11) A method for manufacturing a plasma display panel which comprises manufacturing the display panel by the method for manufacturing a transparent substrate bearing a circuit pattern as described in (5) or (6) above.

ADVANTAGES OF THE INVENTION

The invention has the following advantages over the photolithography/etching process, etc. The number of steps can be reduced to attain a production cost reduction. There is no need of using a large amount of a developing liquid, a chemical, e.g., etchant, or a cleaning liquid, whereby reductions in production cost and in environmental burden can be attained. Materials which had been difficult to etch with an etchant or the like can be used and patterned. Furthermore, a high laser output for patterning is unnecessary. Patterning is hence possible while reducing the damage to the transparent substrate caused by irradiation with YAG laser light.

In this invention, the phrases "can be patterned" and "patterning is possible" and any synonymic phrase mean that when a thin film comprising tin oxide as a main component and formed on a transparent substrate is partly removed from the transparent substrate by irradiation with YAG laser light to form a pattern, then those areas of the thin film comprising tin oxide as a main component which were irradiated with YAG laser light can be distinguished from the unirradiated areas of the thin film with a microscope (enlargement: 150 magnifications). In particular, in the case of forming an electrode pattern for plasma displays, those phrases mean that the insulation between electrode lines is 5 MΩ or higher.

BRIEF DESCRIPTION OF THE DRAWINGS

[Fig. 1] Fig. 1 is a presentation showing carrier concentrations in the Examples according to the invention and the Comparative Examples.

[Fig. 2] Fig. 2 is a diagrammatic view of the basic constitution of the lasers used in the Examples according to the invention.

[Fig. 3(a)] Fig. 3(a) is a top-view photograph (photomicrograph) of the thin-film-attached transparent substrate of Example 1.

[Fig. 3(b)] Fig. 3(b) is a top-view photograph (photomicrograph) of the thin-film-attached transparent substrate of Example 2.

[Fig. 3(c)] Fig. 3(c) is a top-view photograph (photomicrograph) of the thin-film-attached transparent substrate of Example 3.

[Fig. 3(d)] Fig. 3(d) is a top-view photograph (photomicrograph) of the thin-film-attached transparent substrate of Example 4.

[Fig. 3(e)] Fig. 3(e) is a top-view photograph (photomicrograph) of the thin-film-attached transparent substrate of Example 5.

[Fig. 4] Fig. 4 is a top-view photograph (photomicrograph) of the thin-film-attached transparent substrate of Example 8 (Comparative Example) according to the invention.

DESCRIPTION OF THE REFERENCE NUMERALS

1: Oscillator
2: Beam shaper
3: Homogenizer
4: Projection mask
5: Mirror
6: Projection lens
7: Sample

BEST MODE FOR CARRYING OUT THE INVENTION

The invention provides a method for manufacturing a transparent substrate bearing a circuit pattern which comprises irradiating a thin-film-attached transparent substrate comprising a transparent substrate having thereon a transparent conductive film, particularly a thin film comprising tin oxide as a main component, which has a carrier concentration of $5 \times 10^{19}$ /cm$^3$ or higher with a laser light having a wavelength of 1,064 nm to form a circuit pattern on the transparent substrate.

This manufacturing method is hereinafter referred to also as "method of the invention".

The thin-film-attached transparent substrate comprising a transparent substrate having thereon a thin film having a carrier concentration of $5 \times 10^{19}$ /cm$^3$ or higher is hereinafter referred to also as "thin-film-attached transparent substrate of the invention".

Furthermore, the thin film comprising tin oxide as a main component is hereinafter referred to also as "tin oxide thin film".

First, the thin-film-attached transparent substrate of the invention is explained.

In the thin-film-attached transparent substrate of the invention, carrier concentration means the concentration of free electrons in the transparent conductive film, in particular, the tin oxide thin film. The concentration is a value (n) calculated with the following equation (1). Examples of the transparent conductive film include tin oxide thin films and ITO thin films.

$$n = 1/(\rho \cdot \mu \cdot e) \qquad (1)$$

n: carrier concentration (1/cm$^3$)
p: resistivity ($\Omega \cdot$cm)
$\mu$: mobility (cm$^2$/V$\cdot$s)
e: charge (quantum of electricity)

In equation (1), the value of resistivity is a value measured by Van der Pauw's four-terminal method (see L. J. Van der Pauw, Philips Tech, 20, 220 (1958/1959).

The value of mobility is a value measured by a Hall effect measuring method.

In the thin-film-attached transparent substrate of the invention, the tin oxide thin film on the transparent substrate has a carrier concentration as determined by such method of $5 \times 10^{19}$ /cm$^3$. This carrier concentration is preferably $1 \times 10^{20}$ /cm$^3$ or higher.

In the case where the carrier concentration in the tin oxide thin film is in that range, the tin oxide thin film has an increased laser light absorptivity at 1,064 nm, which is the oscillation wavelength of YAG laser light. Consequently, even when irradiated with a pulsed YAG laser light having a low energy density (e.g., 30 J/cm$^2$ or lower) for a short time period (e.g., one or more shots with a pulse duration of 10 nsec or longer; preferably one shot with a pulse duration of 40 nsec), the tin oxide thin film undergoes ablation phenomenon and can hence be patterned. Furthermore, as long as such a laser light is used, damage to the transparent substrate is exceedingly slight. Incidentally, the wavelength of laser light is not limited to 1,064 nm, and the laser light is not particularly limited as long as it is infrared.

Carrier (conduction) electrons in the transparent conductive film (tin oxide thin film) play an important role in the behavior of the film in an infrared region. Namely, infrared light interacts with the conduction electrons and, as a result, resonant absorption occurs at a wavelength corresponding to the carrier (conduction) electron density. The peak of this absorption shifts to the shorter-wavelength side with increasing carrier electron density. This phenomenon is explained below in detail.

A conductor is assumed to be in a kind of plasma state composed of ions and free electrons. According to the Drude's discussion which classically deals with ion polarization and free-electron movement in an electric field (see the Japan Society for Promotion of Scientific Research, The 166th Committee on Photonic and Electronic Oxide ed., Tomei Dodenmaku No Gijutsu, Ohm-sha, Ltd. (1999)), the complex permittivity ε of this conductor is ε=ε$_1$-iε$_2$, wherein

$$\varepsilon_1 = \varepsilon_c - (ne^2/\varepsilon_0 m^*)(\tau^2/\omega^2\tau^2 + 1) \qquad (i)$$

$$\varepsilon_2 = (ne^2/\varepsilon_0 m^*)(\tau/\omega(\omega^2\tau^2 + 1)) \qquad (ii)$$

wherein $\varepsilon_C$ is the permittivity of the ionic field; $\varepsilon_0$ is the permittivity of vacuum; $m^*$ is the effective mass of the free electrons; $\omega$ is the frequency of incident electromagnetic wave; and $\tau$ is relaxation time and represented by $m^*\mu/e$.

When the frequency of incident electromagnetic wave $\omega$ is $\omega_P$ and $\varepsilon_1$ is 0, then resonant absorption of the electromagnetic wave occurs at this frequency $\omega_P$ (=$2\pi c/\lambda_P$). Namely, the conductor has an absorption peak at the following incident-light wavelength:

$$\lambda_P = 2\pi c (ne^2/\varepsilon_0\varepsilon_c m^* - (1/\tau)^2)^{-1/2} \qquad (iii)$$

wherein c is the speed of light.

It can be understood from equation (iii) that the absorption peak $\lambda_P$ changes in proportion to the -1/2 power of carrier concentration n.

In tin oxide thin films, the peak is located at a wavelength of about 2 $\mu$m or longer. The YAG laser wavelength corresponds to the foot of the absorption peak. It is therefore necessary to optimize the absorption characteristics of a tin oxide thin film with satisfactory reproducibility in patterning with a YAG laser so as to remove the tin oxide thin film without fail while preventing the transparent substrate from being damaged. It has been found that this can be attained by optimizing the carrier concentration in the film using equation (iii).

The thickness of the tin oxide thin film is preferably 50-500 $\mu$m, and is more preferably 230-300 nm because such a thickness is effective in obtaining satisfactory reflecting performance.

When the tin oxide thin film has a thickness in that range, this tin oxide thin film not only can be inhibited from reflecting at 1,064 nm, which is the oscillation wavelength of YAG laser light, but also can efficiently absorb the laser light. Consequently, even when irradiated with YAG laser light having a lower energy density, the tin oxide thin film can be patterned. By thus optimizing the carrier concentration of the tin oxide thin film and optimizing the thickness thereof, a transparent substrate provided with a tin oxide thin film capable of being efficiently laser-patterned without fail can be provided; this is an object of the invention.

The tin oxide thin film is a thin film comprising tin oxide as the main component. The term "main component" means that the tin oxide thin film contains tin in an amount of 85% by mass or larger in terms of $SnO_2$ amount based on the film.

This content can be determined, for example, by fluorescent X-ray analysis or by dissolving the tin oxide thin film in a solution and examining the resultant solution using plasma emission, etc.

It is preferred that the tin oxide thin film contains tantalum in an amount of 3-15% by mass in terms of $Ta_2O_5$ amount based on the film. This content is more preferably 5-10% by mass.

When tantalum is contained in an amount within that range, the tin oxide thin film is apt to have a carrier concentration within the preferred range.

It is also preferred that the tin oxide thin film contains antimony in an amount of 3-15% by mass in terms of $Sb_2O_3$ amount based on the film. This content is more preferably 4-10% by mass.

When antimony is contained in an amount within that range, the tin oxide thin film is apt to have a carrier concentration within the preferred range.

Furthermore, it is preferred that the tin oxide thin film contains fluorine in an amount of 0.01-4 mol% based on the film.

When fluorine is contained in an amount within that range, the tin oxide thin film is apt to have a carrier concentration within the preferred range.

As described above, the tin oxide thin film comprises tin oxide as the main component and preferably contains tantalum, antimony, fluorine, and compounds (oxides, etc.) thereof. The thin film may contain other ingredients as long as the effects of the invention are provided. For example, an element which in a pentavalent state forms an oxide, such as, e.g., niobium, may be contained in an amount of up to about 5% by mass in terms of $M_2O_5$ (M is the element which in a pentavalent state forms oxide) amount based on the film.

The thin-film-attached transparent substrate of the invention is a thin-film-attached transparent substrate comprising a transparent substrate having thereon the tin oxide thin film described above.

This transparent substrate is not particularly limited as long as it is constituted of a material which transmits YAG laser light (material having a transmittance of 80% or higher). Examples thereof include glass substrates.

The thickness and size thereof also are not particularly limited. For example, a glass substrate of about 1-3 mm can be advantageously used for plasma display panels (PDPs).

In the method of the invention, the method for manufacturing the thin-film-attached transparent substrate of the invention is explained next.

In the method of the invention, the method for manufacturing the thin-film-attached transparent substrate of the invention is not particularly limited, and ordinary methods can be used. Preferred examples thereof include vapor deposition methods. The vapor deposition methods include physical vapor deposition (PVD), examples of which include vacuum vapor deposition, ion plating, sputtering, and laser ablation. Examples of chemical vapor deposition (CVD) include thermal CVD and plasma-assisted CVD. Of these, sputtering and ion plating are preferred because these techniques are capable of controlling film thickness with satisfactory precision.

For example, in the case of forming a tin oxide thin film on a transparent substrate by sputtering, examples of usable methods include a method which comprises disposing a tin or tin oxide target on the cathode side, causing a glow discharge between the electrodes in a reaction atmosphere gas of about $1\text{-}10^{-2}$ Pa to ionize the reaction atmosphere gas and dislodge tin, etc. from the target, and depositing a coating of tin oxide on a transparent substrate disposed on the anode side. In the case where a tin oxide thin film containing tantalum and antimony is to be deposited, this may be attained by mixing these elements or oxides thereof with the target. The reaction atmosphere gas may be an inert gas such as argon or a gas with which oxygen has been mixed.

By mainly regulating the degree of oxidation of the target, oxygen concentration (partial oxygen pressure) in the reaction atmosphere gas for sputtering, rate of thin-film formation (deposition rate), and substrate temperature, the degree of oxidation of the tin oxide thin film being formed on the transparent substrate is changed and the carrier concentration thereof also is changed.

It is preferred that the thin-film-attached transparent substrate of the invention is manufactured through annealing. It is more preferred that the thin-film-attached transparent substrate is manufactured through vapor deposition and subsequent annealing.

When annealing is conducted in manufacturing the thin-film-attached transparent substrate of the invention, the tin oxide thin film formed on the transparent substrate changes in the degree of oxidation and also in carrier concentration. As a result, the laser light absorptivity at 1,064 nm, which is the oscillation wavelength of YAG laser light, can be optimized, and highly efficient patterning with high reproducibility is possible.

Examples of specific methods for the annealing include a method in which the thin-film-attached transparent substrate is annealed in the air or in an oxygen or nitrogen atmosphere with heating at 300°C-550°C.

In the method of the invention, the thin-film-attached transparent substrate of the invention manufactured by the method described above is patterned by irradiation with YAG laser light having a wavelength of 1,064 nm.

Methods for irradiating the thin-film-attached transparent substrate of the invention with YAG laser light to form a pattern in the method of the invention are not particularly limited. Use may be made of a method in which the main surface of the thin-film-attached transparent substrate of the invention is irradiated with YAG laser light having a wavelength of 1,064 nm and having any desired energy through a mask having any desired opening. The side to be irradiated with YAG laser light may be either the side of the transparent substrate onto which the thin film has been attached or the side opposite thereto. Part of the tin oxide thin film is removed from the transparent substrate by the YAG laser light irradiation, whereby a pattern having the same shape as the opening of the mask can be formed on the transparent substrate.

In conventional methods for manufacturing a transparent substrate bearing a circuit pattern, patterning by irradiation with YAG laser light cannot be conducted with satisfactory reproducibility because properties of the tin oxide thin film have been controlled mainly by regulating visible-light transmittance and resistivity. A higher laser power has been necessary and there have hence been cases where the transparent substrate, e.g., glass, is damaged. On the other hand, in manufacturing a circuit-pattern-bearing transparent substrate by the method of the invention, the transparent conductive film can be efficiently patterned with satisfactory reproducibility using a lower laser power because the carrier concentration of the film, which is a parameter directly determining laser-light-absorbing properties, can be optimized and controlled. As a result, the method of the invention has advantages, for example, that damages of the transparent substrate by an excessive laser power for irradiation can be considerably diminished.

In the method of the invention, examples of preferred embodiments of the thin-film-attached transparent substrate of the invention include one which comprises a transparent substrate having thereon a tin oxide thin film containing tantalum in an amount 3-15% by mass in terms of $Ta_2O_5$ amount and having a carrier concentration of $5\times10^{19}$ /cm$^3$ or higher and a thickness of 50-500 nm.

Examples thereof further include one which comprises a transparent substrate having thereon a tin oxide thin film containing antimony in an amount 3-15% by mass in terms of $Sb_2O_3$ amount and having a carrier concentration of $5\times10^{19}$ /cm$^3$ or higher and a thickness of 50-500 nm.

EXAMPLES

The invention will be illustrated in greater detail by reference to the following Examples, but the invention should not be construed as being limited to the following Examples. Incidentally, Examples 1 to 5 are Invention Examples and Examples 6 to 9 are Comparative Examples.

<Samples>

(EXAMPLES 1 TO 4 AND EXAMPLES 6 TO 9)

A glass substrate which was 40 mm square and had a thickness of 2.8 mm (PD200, manufactured by Asahi Glass Co., Ltd.) was prepared. A tin oxide thin film was formed on a surface of the substrate by the following method. Film formation of a tin oxide thin film was carried out by ion plating using, as a raw vapor deposition material, an $SnO_2$

sinter containing neither tantalum nor antimony nor fluorine or an $SnO_2$ sinter containing $Ta_2O_5$ in an amount of 5% by mass based on the whole, while changing partial oxygen pressure during the film formation and film formation rate. The film formed had the same composition as the sinter.

(EXAMPLE 5)

A glass substrate which was 40 mm square and had a thickness of 2.8 mm (PD200, manufactured by Asahi Glass Co., Ltd.) was prepared. An ITO thin film was formed on a surface of the substrate by the following method. Film formation was carried out by sputtering using an ITO sinter target composed of indium oxide and $SnO_2$ added thereto in an amount of 10% by mass based on the whole. The film formed had the same composition as the sinter.

The film thickness (D [nm]), partial oxygen pressure during film formation/film formation rate ($P_{O2}/D_R$ [Pa/(Å/sec)]), carrier concentration (n [1/cm³]), and laser energy (E [J/cm²]) for each of the samples of Examples 1 to 9 are shown in Table 1. Incidentally, the partial oxygen pressure during film formation/film formation rate ($P_{O2}/D_R$) means the ratio of partial oxygen pressure during film formation relative to film formation rate.

The carrier concentration was determined with equation (1) from the value of mobility measured by a Hall effect measuring method.

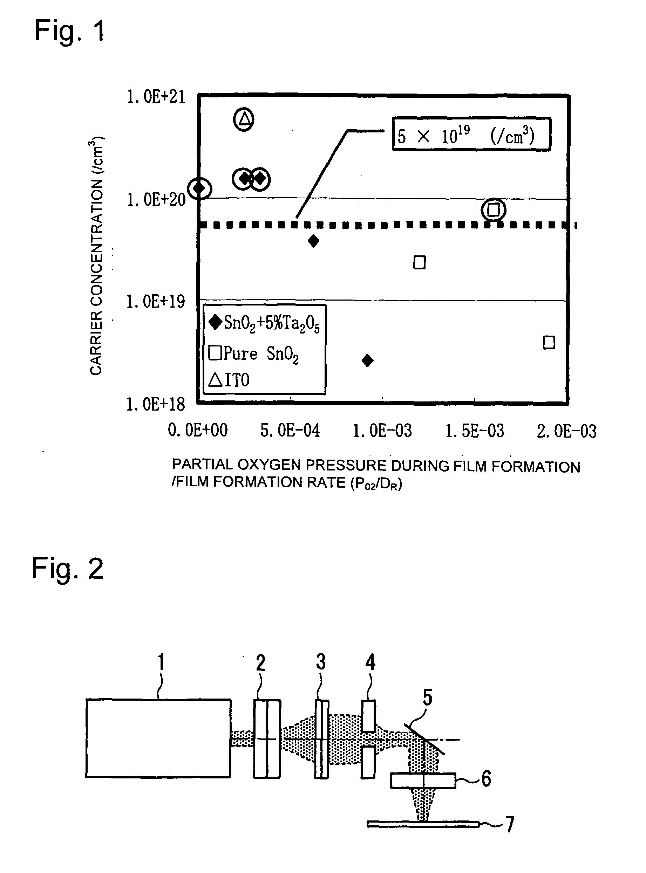

The relationship between the value of partial oxygen pressure during film formation/film formation rate and the carrier concentration in each of the Examples according to the invention and the Comparative Examples is shown in Fig. 1. The points each surrounded by a circle in Fig. 1 mean the data for the films capable of pattern formation.

<Pattern Formation>

The samples obtained by film formation by the methods described above were subjected to pattern formation with AO2 laser (oscillation wavelength: 1,064 nm), which was a Nd:YAG laser manufactured by Power lase, and SL401 laser (oscillation wavelength: 1,064 nm), which was a Nd:YAG laser manufactured by Spectron. The pulse duration used in Examples 1 to 4 and Examples 6 to 9 was 84 nsec, while that in Example 5 was 40 nsec.

The basic constitution of the lasers is shown in Fig. 2. The laser light emitted from an oscillator 1 is caused to directly strike on a sample 7 via a beam shaper 2, homogenizer 3, projection mask 4, mirror 5, and projection lens 6. The projection mask 4 has been partly cut off in a T-bar shape which is suitable for processed-shape evaluation and is used in plasma displays.

[Table 1]

| | | | Film thickness [nm] | $P_{O2}/D_R$ | Carrier concentration [cm⁻³] | Results of processing |
|---|---|---|---|---|---|---|
| Ex. 1 | $SnO_2$ + 5%$Ta_2O_5$ | | 200.0 | 0.0E+00 | 1.2E+20 | 7 J/cm² |
| Ex. 2 | $SnO_2$ + 5%$Ta_2O_5$ | | 200.0 | 2.5E-04 | 1.5E+20 | 11 J/cm² |
| Ex. 3 | $SnO_2$ + 5%$Ta_2O_5$ | | 200.0 | 3.3E-04 | 1.5E+20 | 8 J/cm² |
| Ex. 4 | $SnO_2$ | | 91.8 | 1.6E-03 | 7.7E+19 | 10 J/cm² |
| Ex. 5 | ITO | | 200.0 | 2.5E-04 | 6.0E+20 | 5 J/cm² |
| Ex. 6 | $SnO_2$ + 5%$Ta_2O_5$ | | 200.0 | 6.2E-04 | 3.8E+19 | × |
| Ex. 7 | $SnO_2$ + 5%$Ta_2O_5$ | | 200.0 | 9.2E-04 | 2.6E+18 | × |
| Ex. 8 | $SnO_2$ | | 113.0 | 1.2E-03 | 2.4E+19 | × |
| Ex. 9 | $SnO_2$ | | 87.0 | 1.9E-03 | 3.9E+18 | × |

<EXAMPLES 1 TO 5>

As Table 1 shows, Examples 1 to 4, which were thin-film-attached transparent substrates comprising a transparent substrate having thereon a tin oxide thin film having a carrier concentration of $5 \times 10^{19}$ /cm³ or higher, could be processed with the laser light having a relatively low energy of about 10 J/cm² (in Table 1, the threshold value of laser light energy required for patterning (J/cm²) is shown in the column "Results of processing").

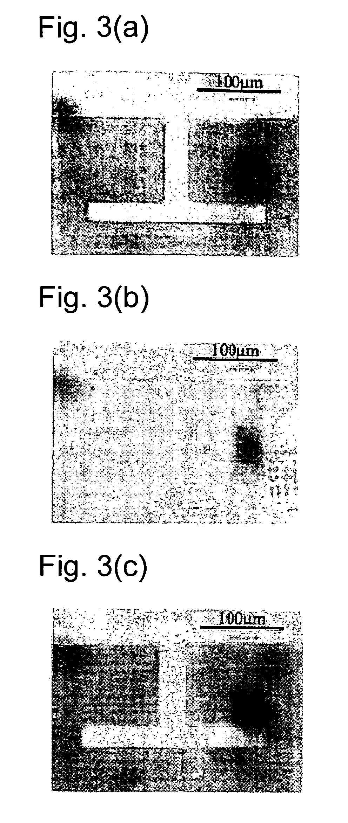

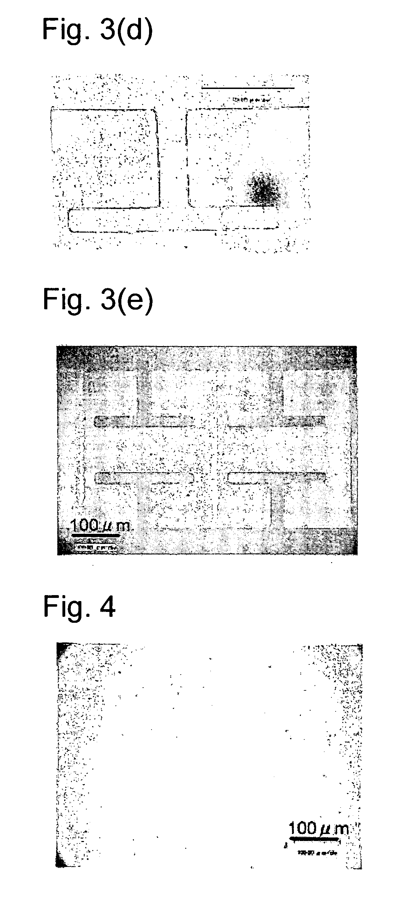

Top-view photographs (photomicrographs) of these patterns are shown in Fig. 3.

The top-view photograph for Example 1 is Fig. 3(a), the top-view photograph for Example 2 is Fig. 3(b), and the top-view photograph for Example 3 is Fig. 3(c). Furthermore, the top-view photograph for Example 4 is Fig. 3(d), and the top-view photograph for Example 5 is Fig. 3(e).
When the thin-film-attached transparent substrates of Examples 1 to 5 are used as an electrode to produce a PDP, no problem arises.

<Examples 6 to 9>

As Table 1 shows, Examples 6 to 9, which were thin-film-attached transparent substrates comprising a transparent substrate having thereon a tin oxide thin film having a carrier concentration lower than $5\times10^{19}$ /cm$^3$, could not be processed with the laser light having an energy of 10 J/cm$^2$ or lower and, in particular, even with the laser light having an energy of 30 J/cm$^2$ or lower (indicated by "$\times$" in Table 1).
Top-view photographs (photomicrographs) of these patterns are shown in Fig. 4.
The top-view photograph for Example 9 is Fig. 4.
While the invention has been described in detail and with reference to specific embodiments thereof, it will be apparent to one skilled in the art that various changes and modifications can be made therein without departing from the spirit and scope thereof.
This application is based on Japanese Patent Application No. 2005-314139 filed on October 28, 2005, the contents thereof being herein incorporated by reference.

INDUSTRIAL APPLICABILITY

As demonstrated by the Invention Examples, the transparent conductive film formed so as to have a high carrier concentration can be patterned with the laser light having a low energy and is hence useful.

## Claims

1. A thin-film-attached transparent substrate, which comprises a transparent substrate having thereon a transparent conductive film having a carrier concentration of $5\times10^{19}$ /cm$^3$ or higher.

2. The thin-film-attached transparent substrate according to claim 1, wherein the transparent conductive film is a thin film comprising tin oxide as a main component.

3. The thin-film-attached transparent substrate according to claim 1 or 2, wherein the transparent conductive film has a thickness of 50-500 nm.

4. The thin-film-attached transparent substrate according to any one of claims 1 to 3, wherein the transparent conductive film can be patterned with a laser light having a wavelength of 1,064 nm.

5. A method for manufacturing a transparent substrate bearing a circuit pattern, which comprises irradiating the thin-film-attached transparent substrate according to any one of claims 1 to 4 with a laser light having a wavelength of 1,064 nm to form a circuit pattern on the transparent substrate.

6. The method for manufacturing a transparent substrate bearing a circuit pattern according to claim 5, wherein the thin-film-attached transparent substrate is obtained by forming a transparent conductive film on a transparent substrate, followed by an annealing treatment.

7. A circuit-pattern-bearing transparent substrate manufactured by the method for manufacturing a transparent substrate bearing a circuit pattern according to claim 5 or 6.

8. An electronic circuit device using the thin-film-attached transparent substrate according to any one of claims 1 to 4 and 7.

9. A plasma display panel using the thin-film-attached transparent substrate according to any one of claims 1 to 4 and 7.

10. A method for manufacturing an electronic circuit device which comprises manufacturing the device by the method for manufacturing a transparent substrate bearing a circuit pattern according to claim 5 or 6.

11. A method for manufacturing a plasma display panel which comprises manufacturing the display panel by the method for manufacturing a transparent substrate bearing a circuit pattern according to claim 5 or 6.

Fig. 1

Fig. 2

Fig. 3(a)

Fig. 3(b)

Fig. 3(c)

Fig. 3(d)

Fig. 3(e)

100 μm

Fig. 4

100 μm

## INTERNATIONAL SEARCH REPORT

International application No.

PCT/JP2006/321294

A. CLASSIFICATION OF SUBJECT MATTER
*H01B5/14*(2006.01)i, *H01B13/00*(2006.01)i, *H01J11/00*(2006.01)i

According to International Patent Classification (IPC) or to both national classification and IPC

B. FIELDS SEARCHED

Minimum documentation searched (classification system followed by classification symbols)
H01B5/14, H01B13/00, H01J11/00

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-14394 A  (Konica Minolta Holdings, Inc.),<br>15 January, 2004 (15.01.04),<br>Claims; Par. Nos. [0020] to [0092], [0107]; Figs. 1 to 8<br>(Family: none) | 1-3,8-9<br>4-7,10-11 |
| X<br>Y | JP 2-168507 A  (Asahi Glass Co., Ltd.),<br>28 June, 1990 (28.06.90),<br>Claims; page 3, upper left column, line 13 to page 4, upper right column, line 1; Figs. 3, 8 to 9<br>(Family: none) | 1-3<br>4-11 |

☒ Further documents are listed in the continuation of Box C.       ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>18 January, 2007 (18.01.07) | Date of mailing of the international search report<br>30 January, 2007 (30.01.07) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/321294 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2001-202826 A  (Gunze Ltd.),<br>27 July, 2001 (27.07.01),<br>Claims; Par. No. [0010]<br>(Family: none) | 4-11 |
| A | WO 2005/076292 A1  (Asahi Glass Co., Ltd.),<br>18 August, 2005 (18.08.05),<br>& US 2006/0270209 A1 | 1-11 |
| A | WO 2004/112057 A1  (Nippon Sheet Glass Co., Ltd.),<br>23 December, 2004 (23.12.04),<br>& EP 1635361 A1 | 1-11 |
| A | JP 2005-108668 A  (Pioneer Plasma Display Corp.),<br>21 April, 2005 (21.04.05),<br>(Family: none) | 1-11 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6013356 A

- JP 10020509 A

**Non-patent literature cited in the description**

- **L. J. VAN DER PAUW.** *Philips Tech,* 1958, vol. 20, 220

- Japan Society for Promotion of Scientific Research, The 166th Committee on Photonic and Electronic Oxide. Ohm-sha, Ltd, 1999